(19) Europäisches Patentamt
European Patent Office
Office européen des brevets

(11) EP 4 759 625 A1

(12) EUROPEAN PATENT APPLICATION
published in accordance with Art. 153(4) EPC

(43) Date of publication:
17.06.2026 Bulletin 2026/25

(21) Application number: 24868676.8

(22) Date of filing: 19.09.2024

(51) International Patent Classification (IPC):
B60L 58/16 (2019.01)        G01R 31/367 (2019.01)
B60L 3/12 (2006.01)

(52) Cooperative Patent Classification (CPC):
B60L 3/12; B60L 58/16; G01R 31/367

(86) International application number:
PCT/KR2024/014112

(87) International publication number:
WO 2025/063699 (27.03.2025 Gazette 2025/13)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(30) Priority: 22.09.2023 KR 20230127482

(71) Applicant: LG Energy Solution, Ltd.
Seoul 07335 (KR)

(72) Inventors:
• SEO, Bo Kyung
Daejeon 34122 (KR)
• PARK, Ki Bum
Daejeon 34122 (KR)
• RO, Chang Suk
Daejeon 34122 (KR)

(74) Representative: Plasseraud IP
104 Rue de Richelieu
CS92104
75080 Paris Cedex 02 (FR)

(54) **BATTERY DIAGNOSIS APPARATUS AND OPERATING METHOD THEREOF**

(57) A battery diagnosis apparatus according to an embodiment disclosed herein includes a communication circuit configured to obtain a cumulative mileage of a diagnosis target vehicle and a cumulative discharging energy of a battery mounted on the diagnosis target vehicle and obtain reference energy efficiencies of a plurality of vehicles of a same model as the diagnosis target vehicle, a first processor configured to calculate a threshold value, which is a criterion for replacement of a battery, based on the reference energy efficiencies, and a second processor configured to calculate a cumulative energy efficiency based on the cumulative mileage and the cumulative discharging energy and diagnose whether the battery has been replaced, based on the cumulative energy efficiency and the threshold value.

FIG.1

# EP 4 759 625 A1

**Description**

## TECHNICAL FIELD

CROSS-REFERENCE TO RELATED APPLICATION

This application claims priority to and the benefit of Korean Patent Application No. 10-2023-0127482 filed in the Korean Intellectual Property Office on September 22, 2023, the entire content of which is incorporated herein by reference.

TECHNICAL FIELD

Embodiments disclosed herein relate to a battery diagnosis apparatus and an operating method thereof.

## BACKGROUND ART

Recently, research and development of secondary batteries have been actively performed. Herein, the secondary batteries, which are chargeable/dischargeable batteries, may include all of conventional nickel (Ni)/cadmium (Cd) batteries, Ni/metal hydride (MH) batteries, etc., and recent lithium-ion batteries. Among the secondary batteries, a lithium-ion battery has a much higher energy density than those of conventional Ni/Cd batteries, Ni/MH batteries, etc. Moreover, the lithium-ion battery may be manufactured to be small and lightweight, such that the lithium-ion battery has been used as a power source of mobile devices, and recently, a use range thereof has been extended to power sources for electric vehicles, attracting attention as next-generation energy storage media.

Batteries mounted on electric vehicles are consumables and are replaceable. A lifetime of a battery may differ with a scheme to drive an electric vehicle, the number of times of charge or discharge, and/or a manufacturer of the battery. Thus, to determine the lifetime of the battery, it is necessary to determine whether the battery mounted on the vehicle is a replaced battery, and it may be difficult for a driver having purchased a used electric vehicle to identify whether a battery has been replaced.

## DISCLOSURE

## TECHNICAL PROBLEM

Generally, unless there is a mass recall for electric vehicles, an owner of an electric vehicle may not be able to identify whether a battery has been replaced.

When a threshold value that is a criterion for battery replacement is calculated using data of vehicles with batteries not having been replaced, sufficient parameters of the threshold value may not be secured.

Technical problems of the embodiments disclosed herein are not limited to the above-described technical problems, and other unmentioned technical problems would be clearly understood by one of ordinary skill in the art from the following description.

## TECHNICAL SOLUTION

A battery diagnosis apparatus according to an embodiment disclosed herein includes a communication circuit configured to obtain a cumulative mileage of a diagnosis target vehicle and a cumulative discharging energy of a battery mounted on the diagnosis target vehicle and obtain reference energy efficiencies of a plurality of vehicles of a same model as the diagnosis target vehicle, a first processor configured to calculate a threshold value, which is a criterion for replacement of a battery, based on the reference energy efficiencies, and a second processor configured to calculate a cumulative energy efficiency based on the cumulative mileage and the cumulative discharging energy and diagnose whether the battery has been replaced, based on the cumulative energy efficiency and the threshold value.

In an embodiment, each of the reference energy efficiencies may be calculated each time when each of the plurality of vehicles starts traveling and ends the traveling for a designated time.

In an embodiment, the first processor may be further configured to calculate the threshold value using an inter quartile range (IQR) for the reference energy efficiencies.

In an embodiment, the second processor may be further configured to diagnose whether the battery has been replaced, based on a result of comparing the cumulative energy efficiency with the threshold value.

In an embodiment, the second processor may be further configured to diagnose the battery as a replaced battery when the cumulative energy efficiency exceeds the threshold value.

In an embodiment, the first processor may be further configured to extract a representative energy efficiency representing an energy efficiency of the diagnosis target vehicle based on an average and a standard deviation of the reference energy efficiencies, and the second processor may be further configured to calculate a cumulative mileage after replacement from a point in time when the battery is mounted on the diagnosis target vehicle, based on the representative energy efficiency and the cumulative discharging energy of the battery.

In an embodiment, the communication circuit may be further configured to transmit diagnosis information including whether the battery has been replaced to a user terminal.

An operating method of a battery diagnosis apparatus according to an embodiment disclosed herein includes obtaining a cumulative mileage of a diagnosis target vehicle and a cumulative discharging energy of a battery mounted on the diagnosis target vehicle, obtaining reference energy efficiencies of a plurality of vehicles of a same model as the diagnosis target vehicle, calculating a threshold value, which is a criterion for replacement of a battery, based on the reference energy efficiencies, calculating a cumulative energy efficiency based on the cumulative mileage and the cumulative discharging energy, and diagnosing whether the battery has been replaced, based on the cumulative energy efficiency and the threshold value.

In an embodiment, each of the reference energy efficiencies may be calculated each time when each of the plurality of vehicles starts traveling and ends the traveling for a designated time.

In an embodiment, the calculating of the threshold value may include calculating the threshold value by using an inter quartile range (IQR) for the reference energy efficiencies.

In an embodiment, the diagnosing may include diagnosing whether the battery has been replaced, based on a result of comparing the cumulative energy efficiency with the threshold value.

In an embodiment, the diagnosing may include diagnosing the battery as a replaced battery when the cumulative energy efficiency exceeds the threshold value.

In an embodiment, the operating method may further include extracting a representative energy efficiency representing an energy efficiency of the diagnosis target vehicle based on an average and a standard deviation of the reference energy efficiencies and calculating a cumulative mileage after replacement from a point in time when the battery is mounted on the diagnosis target vehicle, based on the representative energy efficiency and the cumulative discharging energy.

In an embodiment, the operating method may further include transmitting diagnosis information including whether the battery has been replaced to a user terminal.

## ADVANTAGEOUS EFFECTS

A battery diagnosis apparatus and an operating method thereof according to various embodiments disclosed herein may diagnose whether a battery has been replaced, based on a cumulative mileage of a vehicle and a cumulative discharging energy of the battery. Thus, by using data regarding the vehicle and data regarding the battery mounted on the vehicle, it may be more accurately determined whether the battery has been replaced.

The battery diagnosis apparatus and the operating method thereof according to various embodiments disclosed herein may use data regarding all vehicles and/or batteries regardless of whether the batteries have been replaced, thereby securing a sufficient number of pieces of data to calculate a threshold value that is a criterion for battery replacement determination.

The technical effects of the battery diagnosis apparatus and the operating method thereof according to embodiments disclosed in the present document are not limited to the effects mentioned above, and other effects not mentioned will be clearly understood by those of ordinary skill in the art according to the disclosure of the present document.

## DESCRIPTION OF DRAWINGS

FIG. 1 illustrates a battery diagnosis system according to an embodiment disclosed herein.
FIG. 2 is a block diagram of a battery diagnosis apparatus, according to an embodiment disclosed herein.
FIG. 3 is a cumulative discharging energy-cumulative mileage graph according to an embodiment disclosed herein.
FIGS. 4A and 4B show a reference energy efficiency graph and an analysis table based on the reference energy efficiency graph, according to an embodiment disclosed herein.
FIG. 5 shows a cumulative energy efficiency graph according to an embodiment disclosed herein.
FIG. 6 is a flowchart showing an operating method of a battery diagnosis apparatus according to an embodiment disclosed herein.
FIG. 7 is a flowchart showing a detailed operating method of operation 606 of a battery diagnosis apparatus according to an embodiment disclosed herein.

FIG. 8 is a flowchart showing a method, performed by a battery diagnosis apparatus, of calculating a cumulative mileage after replacement, according to an embodiment disclosed herein.

With regard to the description of the drawings, identical or similar reference numerals may be used to refer to identical or related elements.

**MODE FOR INVENTION**

Hereinafter, embodiments of the present disclosure will be described with reference to the accompanying drawings. However, the description is not intended to limit the present disclosure to particular embodiments, and it should be construed as including various modifications, equivalents, and/or alternatives according to the embodiments of the present disclosure.

It should be appreciated that embodiments of the present document and the terms used therein are not intended to limit the technological features set forth herein to a particular embodiment and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise.

As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. Such terms as "1st", "2nd," "first", "second", "A", "B", "(a)", or "(b)" may be used to simply distinguish a corresponding component from another, and does not limit the components in other aspect (e.g., importance or order), unless mentioned otherwise.

Herein, it is to be understood that when an element (e.g., a first element) is referred to, with or without the term "operatively" or "communicatively", as "connected with", "coupled with", or "linked with", or "coupled to" or "connected to" to another element (e.g., a second element), it means that the element may be connected with the other element directly (e.g., wiredly or wirelessly), or indirectly (e.g., via a third element).

A method according to various embodiments disclosed herein may be included and provided in a computer program product. The computer program product may be traded as a product between a seller and a buyer. In the case of online distribution, at least a part of a computer program product may be at least temporarily stored in a machine-readable storage medium such as a memory of a server of a manufacturer, a server of an application store, or a relay server, or may be generated temporarily. In the case of online distribution, at least a part of a computer program product may be at least temporarily stored in a machine-readable storage medium such as a memory of a server of a manufacturer, a server of an application store, or a relay server, or may be generated temporarily.

According to embodiments disclosed herein, each of the above-described components (e.g., a module or program) may include a single entity or a plurality of entities, some of which may be separately disposed on other components. According to embodiments disclosed herein, one or more of the above-described components or operations may be omitted, or one or more other components or operations may be added. Alternatively or additionally, a plurality of components (e.g., modules or programs) may be integrated into one component. In this case, the integrated component may perform one or more functions of each of the plurality of components in a manner that is the same as or similar to a corresponding component of the plurality of components before the integration. According to embodiments disclosed herein, operations performed by a module, a program, or other components may be executed sequentially, in parallel, repeatedly, or heuristically, or one or more of the operations may be executed in a different order or omitted, or one or more other operations may be added.

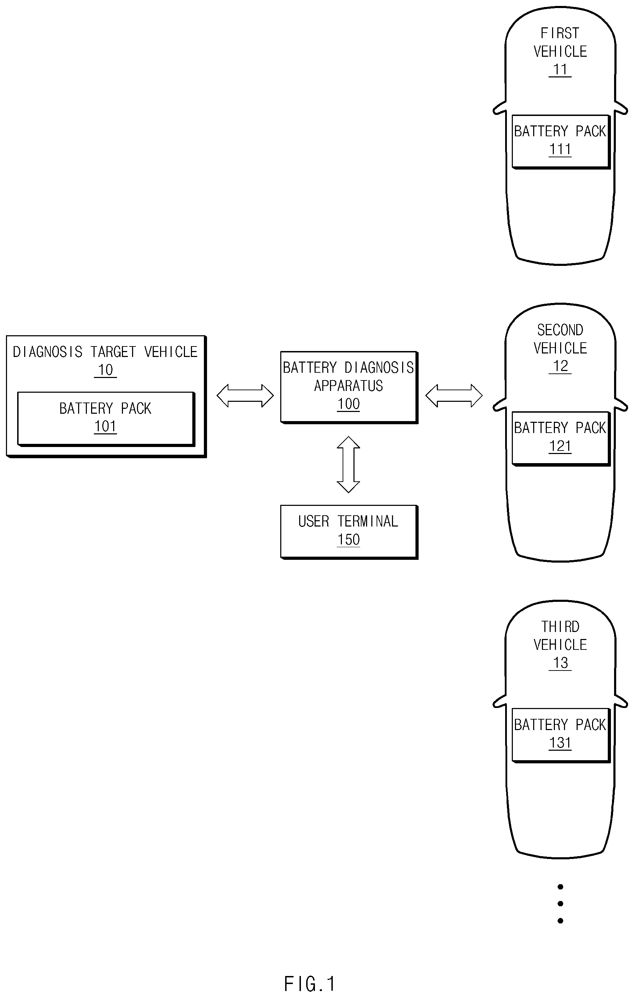

FIG. 1 illustrates a battery diagnosis system according to an embodiment disclosed herein.

Referring to FIG. 1, the battery diagnosis system may include a diagnosis target vehicle 10, a plurality of vehicles 11, 12, and 13, a battery diagnosis apparatus 100, and a user terminal 150.

The diagnosis target vehicle 10 may be a vehicle for which the battery diagnosis apparatus 100 is to diagnose whether a battery pack has been replaced. The plurality of vehicles 11, 12, and 13 may be vehicles of the same vehicle model as the diagnosis target vehicle 10. According to an embodiment, the diagnosis target vehicle 10 may be one of the plurality of vehicles 11, 12, and 13. While it is shown in FIG. 1 that the plurality of vehicles 11, 12, and 13 are three vehicles, the present disclosure is not limited thereto.

All the vehicles 10, 11 12, and 13 shown in FIG. 1 may respectively include battery packs 101, 111, 121, and 131. The battery packs 101, 111, 121, and 131 may include a plurality of battery cells. According to an embodiment, the plurality of battery cells may include, but not limited to, a lithium-ion (Li-ion) battery, an Li-ion polymer battery, a nickel-cadmium (Ni-Cd) battery, a nickel metal hydride (Ni-MH) battery, a lithium iron phosphate (LFP) battery, a nickel cobalt manganese oxide (NCM) battery, etc. The battery packs 101, 111, 121, and 131 may respectively supply power to the vehicles 10, 11, 12, and 13. To this end, the battery packs 101, 111, 121, and 131 may be respectively electrically connected to the vehicles 10, 11, 12, and 13.

Connection between the battery diagnosis apparatus 100 and all the vehicles 10, 11, 12, and 13 and/or the user terminal 150 shown in FIG. 1 may be communication connection made via a wired and/or wireless network. The battery diagnosis apparatus 100 may receive transmit and receive data to and from all the vehicles 10, 11, 12, and 13 and/or the user terminal 150 shown in FIG. 1 via the wired and/or wireless network.

In an embodiment, connection between the battery diagnosis apparatus 100 and all the vehicles 10, 11, 12, and 13 and/or the user terminal 150 shown in FIG. 1 may be communication connection made via a wired and/or wireless network. In an embodiment, the wired network may be based on a local area network (LAN) communication or a power-line communication. In an embodiment, the wireless network may be based on a short-range communication network (e.g., Bluetooth, Wireless Fidelity (WiFi), or Infrared Data Association (IrDA)) or a remote-range communication network (e.g., a cellular network, a 4th-Generation (4G) network, a 5th-Generation (5G) network).

In an embodiment, the connection between the battery diagnosis apparatus 100 and all the vehicles 10, 11, 12, and 13 and/or the user terminal 150 shown in FIG. 1 may be connection using a device-to-device communication scheme (e.g., a bus, a general-purpose input and output (GPIO), a serial peripheral interface (SPI), or a mobile industry processor interface (MIPI)).

Hereinbelow, a description will be made of a method, performed by the battery diagnosis apparatus 100, of diagnosing whether the battery pack 101 included in the diagnosis target vehicle 10 has been replaced.

Hereinbelow, a description will be made in which the first vehicle 11 to the third vehicle 13 are the plurality of vehicles on the assumption that the diagnosis target vehicle 10 is not included in the plurality of vehicles 11, 12, and 13.

The battery diagnosis apparatus 100 may diagnose whether the battery pack 101 included in the diagnosis target vehicle 10 has been replaced. The battery diagnosis apparatus 100 may diagnose based on reference energy efficiencies of the plurality of vehicles 11, 12, and 13 and a cumulative energy efficiency of the diagnosis target vehicle 10 whether the battery pack 101 has been replaced. Herein, the reference energy efficiency may be an energy efficiency calculated based on a specific criterion (e.g., a designated period or a designated condition). For example, the reference energy efficiency may be an average energy efficiency calculated each time when driving starts and ends for each of the plurality of vehicles 11, 12, and 13 for one month. The cumulative energy efficiency may be an indicator for diagnosing whether the battery pack 101 has been replaced. This is because when the battery pack 101 is replaced, a cumulative mileage of a diagnosis target vehicle is not initialized, but a cumulative discharging energy may be initialized, such that cumulative energy efficiencies before and after replacement of the battery pack 101 may be different from each other.

Hereinbelow, a description will be made of a method, performed by the battery diagnosis apparatus 100, of diagnosing based on the reference energy efficiencies of the plurality of vehicles 11, 12, and 13 and the cumulative energy efficiency of the diagnosis target vehicle 10 whether the battery pack 101 has been replaced.

The battery diagnosis apparatus 100 may obtain reference energy efficiencies respectively calculated for a designated time for the plurality of vehicles 11, 12, and 13. According to an embodiment, the reference energy efficiency may be calculated based on cumulative energy efficiencies and cumulative discharging energies in at least two points in time. The reference energy efficiency may be expressed as a slope value between a cumulative discharging energy at a first point in time with respect to a cumulative mileage at the first point in time and a cumulative discharging energy at a second point in time, which precedes the first point in time, with respect to a cumulative mileage at the second point in time, on a two-dimensional (2D) coordinate plane.

The battery diagnosis apparatus 100 may calculate a threshold value that is a criterion for determining whether the battery pack 101 has been replaced, based on the reference energy efficiencies. The threshold value may indicate a reference value with which an energy efficiency of a vehicle may be calculated as a random value from a maximum value to a minimum value based on a reference energy efficiency. The threshold value may be calculated based on an average, a standard deviation, a maximum value, and/or a minimum value of reference energy efficiencies.

The battery diagnosis apparatus 100 may obtain a cumulative mileage of the diagnosis target vehicle 10 and a cumulative discharging energy of the battery pack 101. Herein, the cumulative mileage may be a cumulative distance by which the diagnosis target vehicle 10 travels up to a specific point in time, and the cumulative discharging energy may be a total energy quantity discharged from a point in time when the battery pack 10 is mounted on the diagnosis target vehicle 10.

The battery diagnosis apparatus 100 may calculate the cumulative energy efficiency of the diagnosis target vehicle 10 based on the cumulative mileage and the cumulative discharging energy. Herein, the cumulative energy efficiency may be calculated based on a value obtained by dividing the cumulative mileage by the cumulative discharging energy. According to an embodiment, the cumulative energy efficiency may be expressed as a slope value based on the cumulative discharging energy with respect to the cumulative mileage on the 2D coordinate plane.

The battery diagnosis apparatus 100 may diagnose whether the battery pack 101 has been replaced, based on the cumulative energy efficiency and the threshold value.

When diagnosing that the battery pack 101 is a replaced battery pack, the battery diagnosis apparatus 100 may extract a representative energy efficiency representing the energy efficiency of the diagnosis target vehicle 10 based on an average and a standard deviation of reference energy efficiencies. For example, the representative energy efficiency may be an average or a median of the reference energy efficiencies of the plurality of vehicles 11, 12, and 13.

The battery diagnosis apparatus 100 may calculate, based on the representative energy efficiency and the cumulative discharging energy of the battery pack 101, a cumulative mileage after replacement, which is a cumulative mileage from a point in time when the battery pack 101 is mounted on the diagnosis target vehicle.

The battery diagnosis apparatus 100 may transmit, to the user terminal 150, a diagnosis result including whether the battery pack 101 has been replaced. Herein, the user terminal 150 may be a device that controls the battery diagnosis apparatus 100 and/or receives the diagnosis result from the battery diagnosis apparatus 100 and may be a mobile device (e.g., a mobile phone, a laptop computer, a smart phone, a smart pad) or a personal computer (PC). In an embodiment, the user terminal 150 may be included in the battery diagnosis apparatus 100.

In an embodiment, the battery diagnosis apparatus 100 may be included in a battery management system (BMS) capable of diagnosing the battery pack 101, and operations performed in the battery diagnosis apparatus 100 may be performed in the BMS. The following operation of the battery diagnosis apparatus 100 may also be performed in various devices such as not only a BMS in a vehicle, but also a server, a cloud, a charger, a charger/discharger, etc.

The battery diagnosis apparatus 100 may diagnose whether the battery pack 101 has been replaced, based on the cumulative mileage of the vehicle and the cumulative discharging energy of the battery pack 101, thereby enabling an owner having purchased even the used vehicle to easily identify whether the battery pack 101 has been replaced.

When diagnosing that the battery pack 101 is a replaced battery pack, the battery diagnosis apparatus 100 may calculate a mileage from a point in time when the battery pack 101 is replaced, thereby more clearly diagnosing a cause for a problem occurring in the vehicle.

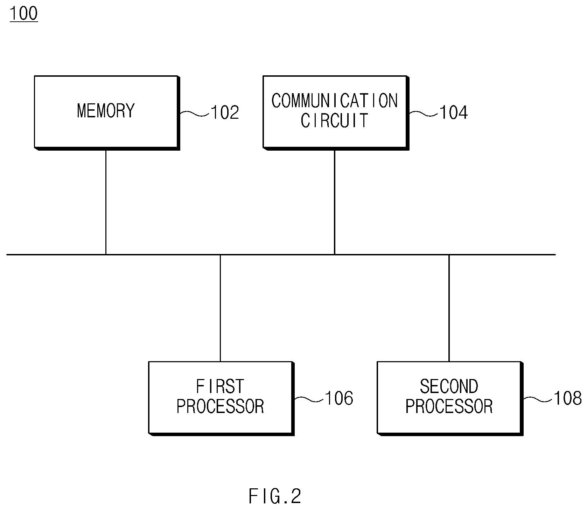

FIG. 2 is a block diagram of a battery diagnosis apparatus, according to an embodiment disclosed herein.

Referring to FIG. 2, the battery diagnosis apparatus 100 may include a memory 102, a communication circuit 104, a first processor 106, and a second processor 108. According to an embodiment, the battery diagnosis apparatus 100 shown in FIG. 2 may further include at least one component (e.g., a sensor, a display, an input device, or an output device) in addition to components shown in FIG. 2.

The memory 102 may include a volatile and/or a nonvolatile memory.

In an embodiment, the memory 102 may include one or more software.

In an embodiment, the memory 102 may store data used by at least one component (e.g., the processors 106 and 108) of the battery diagnosis apparatus 100. For example, the data may include software (or an instruction related thereto), input data, or output data. In an embodiment, the instruction, when executed by each of the processors 106 and 108, may cause the battery diagnosis apparatus 100 to perform operations defined by the instruction.

The communication circuit 104 may obtain reference energy efficiencies respectively calculated for the plurality of vehicles 11, 12, and 13. The communication circuit 104 may obtain reference energy efficiencies respectively calculated for a designated time for the plurality of vehicles 11, 12, and 13.

The first processor 106 may calculate a threshold value that is a criterion for determining whether the battery pack 101 has been replaced, based on the reference energy efficiencies. The threshold value may indicate a reference value with which an energy efficiency of a vehicle may be calculated as a random value from a maximum value to a minimum value based on a reference energy efficiency. In an embodiment, the threshold value may be calculated using an inter quartile range (IQR) for the reference energy efficiencies. In an embodiment, the first processor 106 may calculate the threshold value based on a maximum value among values remaining after removing an outlier from among the reference energy efficiencies calculated for the designated time. In an embodiment, the first processor 106 may calculate the threshold value based on a third quartile Q3. For example, the first processor 106 may calculate an IQR based on a first quartile Q1 and the third quartile Q3 and calculate the threshold value by using Equation 1.

$$[\text{Equation 1}]$$

$$\text{Threshold Value} = Q3 + 1.5 \times IQR$$

The communication circuit 104 may obtain a cumulative mileage of the diagnosis target vehicle 10 from the diagnosis target vehicle 10. Herein, the cumulative mileage may be a value obtained by accumulating a mileage of the vehicle up to a specific point in time. The cumulative mileage may be stored in a memory of the diagnosis target vehicle 10.

The communication circuit 104 may obtain the cumulative discharging energy of the battery pack 101. Herein, the cumulative discharging energy may be a sum of energy amount discharged up to a specific point in time from a point in time when the battery pack 101 is mounted on the diagnosis target vehicle 10. The cumulative discharging energy may be stored in the memory 102.

The second processor 108 may calculate the cumulative energy efficiency of the diagnosis target vehicle 10 based on the cumulative mileage and the cumulative discharging energy. Herein, the cumulative energy efficiency may be a value obtained by dividing the cumulative mileage by the cumulative discharging energy regardless of whether the battery pack 101 has been replaced. The cumulative energy efficiencies before and after replacement may be different from each other according to whether the battery pack 101 has been replaced. That is, once the battery pack 101 is replaced, the cumulative discharging energy of the battery pack 101 is initialized, such that the cumulative energy efficiency may be calculated as being higher than when the battery pack 101 is not replaced.

The second processor 108 may diagnose whether the battery pack 101 has been replaced, based on the cumulative energy efficiency and the threshold value. The second processor 108 may diagnose whether the battery pack 101 has been replaced, based on a result of comparing the cumulative energy efficiency with the threshold value.

In an embodiment, the second processor 108 may diagnose whether the battery pack 101 has been replaced, based on whether the cumulative energy efficiency exceeds the threshold value. The second processor 108 may diagnose that the battery pack 101 has been replaced, when the cumulative energy efficiency exceeds the threshold value. The second processor 108 may diagnose that the battery pack 101 has not been replaced, when the cumulative energy efficiency is less than or equal to the threshold value.

So far, it has been described that replacement of the battery pack 101 is determined based on that the cumulative energy efficiency exceeds the threshold value, but the present disclosure is not limited thereto and there may be various embodiments such as where the cumulative energy efficiency is less than or equal to and/or less than a minimum threshold value or does not fall within a threshold range. However, hereinbelow, it will be described assuming that whether the battery pack 101 has been replaced is diagnosed based on that the cumulative energy efficiency exceeds the threshold value for convenience of a description.

The first processor 106 may extract a representative energy efficiency based on reference energy efficiencies. The first processor 106 may extract a representative energy efficiency based on an average and a standard deviation of the reference energy efficiencies. For example, the representative energy efficiency may be extracted based on an average or a median of the reference energy efficiencies of the plurality of vehicles 11, 12, and 13. In an embodiment, for a vehicle of a model generally having a high reference energy efficiency, the representative energy efficiency may be extracted based on a value obtained by adding the standard deviation to the average of the reference energy efficiencies. On the other hand, for a vehicle of a model generally having a low reference energy efficiency, the representative energy efficiency may be extracted based on a value obtained by subtracting the standard deviation from the average of the reference energy efficiencies.

When the battery pack 101 is diagnosed as a replaced battery pack, the second processor 108 may calculate may calculate a cumulative mileage after replacement, which indicates a mileage from a replacement point in time. Herein, the cumulative mileage after replacement may be a cumulative mileage from the replacement point in time up to a specific point in time (e.g., the current point in time). The second processor 108 may calculate a mileage after replacement by using Equation 2.

$$\text{Cumulative Mileage after Replacement} = \text{Representative Energy Efficiency} \times \text{Cumulative Discharging Energy} \qquad \text{[Equation 2]}$$

In an embodiment, the first processor 106 and the second processor 108 may include a central processing unit, an application processor, a graphic processing unit, a neural processing unit (NPU), an image signal processor, a sensor hub processor, or a communication processor.

In an embodiment, the first processor 106 and the second processor 108 may execute software to control at least one other component (e.g., a hardware or software component) of the battery diagnosis apparatus 100 connected to the first processor 106 and the second processor 108 or perform various data processing or operations.

The above-described operations performed by the first processor 106 and the second processor 108 may also be performed by one processor.

The communication circuit 104 may transmit a diagnosis result to the user terminal 150. Herein, the user terminal 150 may be a device that controls the battery diagnosis apparatus 100 and/or receives a diagnosis result from the battery diagnosis apparatus 100.

In an embodiment, the communication circuit 104 may establish a wired communication channel and/or a wireless communication channel between the battery diagnosis apparatus 100 and all the vehicles 10, 11, 12, and 13 shown in FIG. 1 and transmit and receive data to and from all the vehicle 10, 11, 12, and 13 shown in FIG. 1 through the established communication channel.

In an embodiment, the communication circuit 104 of the battery diagnosis apparatus 100 may establish the wired communication channel and/or the wireless communication channel between the battery diagnosis apparatus 100 and the user terminal 150 and/or the vehicles 10, 11, 12, and 13 and transmit and receive data to and from the user terminal 150 and/or the vehicles 10, 11, 12, and 13 through the established communication channel.

In an embodiment, when operations of the battery diagnosis apparatus 100 are performed by a BMS included in the battery pack 101 of the diagnosis target vehicle 10, the battery diagnosis apparatus 100 may not include the first processor 106. In this case, the operations of the first processor 106 may be performed by an external device, and the battery diagnosis apparatus 100 may obtain a threshold value and/or a representative energy efficiency from the external device through the communication circuit 104.

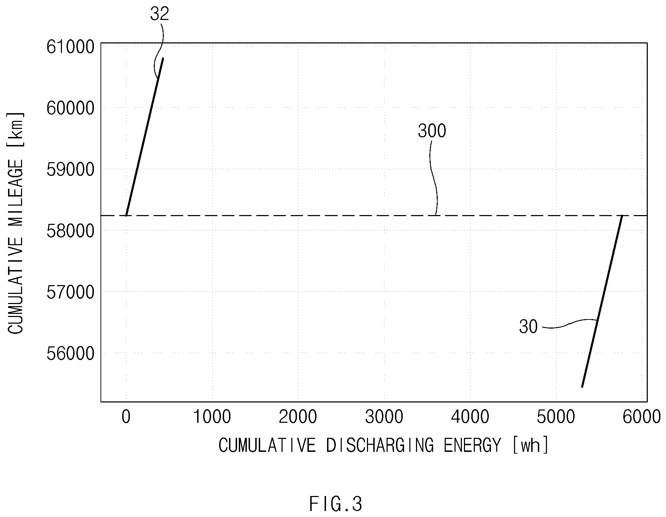

FIG. 3 is a cumulative discharging energy-cumulative mileage graph according to an embodiment disclosed herein.

Referring to FIG. 3, the battery diagnosis apparatus 100 may generate a cumulative discharging energy-cumulative mileage graph to identify a change in a cumulative discharging energy and a cumulative mileage.

The battery diagnosis apparatus 100 may determine from the graph whether the battery pack 101 has been replaced. For example, a first graph 30 is generated when the battery pack 101 has not been replaced, but when the battery pack 101 is replaced, the cumulative discharging energy is initialized such that the first graph 30 and a second graph 32 may be generated. For example, the first graph 30 and the second graph 32 may be distinguished based on a cumulative mileage 300 at a point in time when the battery pack 101 is replaced.

In an embodiment, the graph may include a cumulative mileage with respect to a cumulative discharging energy for each of the battery pack before replacement and the battery pack 101 after replacement, when the battery pack 101 is a replaced battery pack. The first graph 30 may be data based on the battery pack before replacement, and the second graph 32 may be data based on the battery pack 101 after replacement. That is, it may be determined that when the battery pack 101 is a replaced battery pack, the cumulative discharging energy is initialized, but the cumulative mileage is not initialized.

The battery diagnosis apparatus 100 may calculate a cumulative energy efficiency of a battery pack after replacement. Assuming that both an initial cumulative mileage and an initial cumulative discharging energy are 0, the battery diagnosis apparatus 100 may calculate a cumulative energy efficiency of a battery after replacement as 143.2 based on a slope value between (0, 0) and coordinates of a first cumulative discharging energy and a first cumulative mileage, (424.5, 60790). Meanwhile, when the cumulative energy efficiency of the battery pack before replacement is calculated in the same manner as calculation of the cumulative energy efficiency of the battery pack after replacement, the cumulative energy efficiency of the battery pack before replacement may be calculated as 10.09 that is a slope value between (0, 0) and (5773, 58248). For example, when the threshold value is 11 km/kWh, the battery diagnosis apparatus 100 may diagnose that the battery pack is a replaced battery pack because the cumulative energy efficiency (143.2 km/kWh) exceeds the threshold value 11 km/kWh.

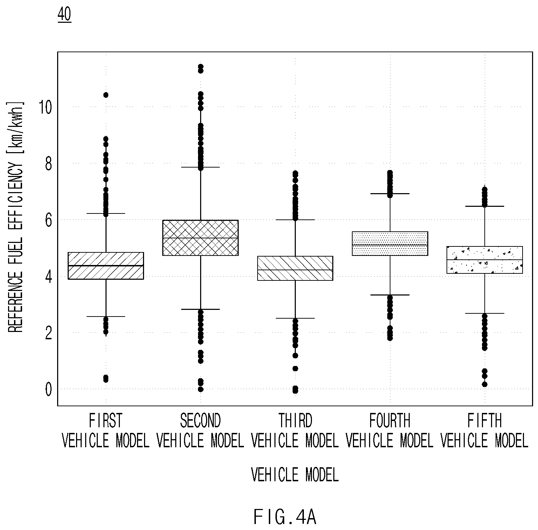

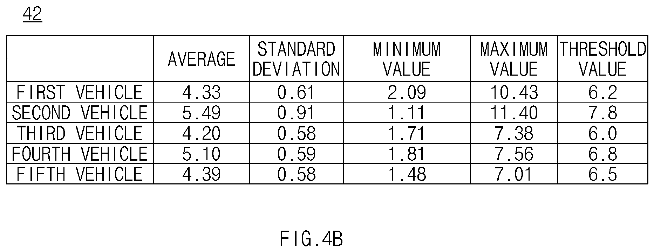

FIGS. 4A and 4B show a reference energy efficiency graph and an analysis table based on the reference energy efficiency graph, according to an embodiment disclosed herein.

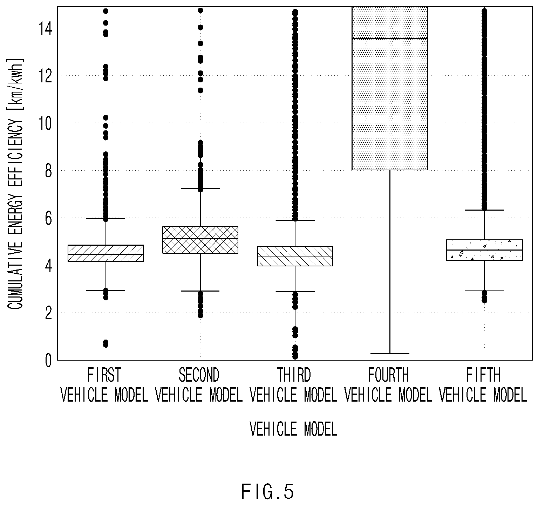

Referring to FIGS. 4A and 4B, a reference energy efficiency graph 40 may include reference energy efficiencies calculated for a designated time for each of first to fifth vehicle models. Herein, the first to fifth vehicle models may be different vehicle models, and may each a single vehicle or may be a plurality of vehicles of the same vehicle model. In FIG. 5, it will be described assuming that the first to fifth vehicle models may be respectively a plurality of vehicles of the same vehicle model and the energy efficiency graph 40 may be generated based on data of the plurality of vehicles respectively included in the first to fifth vehicle models.

The designated time may be, for example, one month, and the reference energy efficiency may be calculated every specific period for one month. In an embodiment, the reference energy efficiency may be calculated every driving of 10 km for a designated time of one month. In an embodiment, when the reference energy efficiency is calculated every one month for a designated time of one year, 12 reference energy efficiencies of the vehicle may be calculated. In an embodiment, when the reference energy efficiency is calculated every one week for a designated time of one year, 54 reference energy efficiencies of the vehicle may be calculated.

The battery diagnosis apparatus 100 may generate an analysis table 42 based on the reference energy efficiency graph 40. The analysis table 42 may include an average, a standard deviation, a minimum value, a maximum value, and a threshold value of reference energy efficiencies respectively for the first to fifth vehicle models. Herein, the threshold value may be calculated based on the foregoing IQR scheme.

Referring to the reference energy efficiency graph 40 and the analysis table 42, the battery diagnosis apparatus 100 may calculate the threshold value based on reference energy efficiencies for all the vehicles regardless of whether the battery is replaced, such that even when a massive recall occurs for a specific vehicle model, reference energy efficiencies may be obtained from all vehicles of the corresponding vehicle model to calculate a threshold value, regardless of whether batteries have been replaced. Thus, by using not only reference energy efficiencies of vehicles with batteries not replaced, but also reference energy efficiencies of vehicles with replaced batteries, the battery diagnosis apparatus 100 may secure a sufficient number of pieces of data.

FIG. 5 shows a cumulative energy efficiency graph according to an embodiment disclosed herein.

Referring to FIG. 5, the cumulative energy efficiency graph may include the cumulative energy efficiency calculated most recently for each of a plurality of vehicle models.

The battery diagnosis apparatus 100 may generate the cumulative energy efficiency graph. The cumulative energy efficiency graph may include cumulative energy efficiencies for the first to fifth vehicle models. Herein, the first to fifth vehicle models may be different vehicle models, and may each a single vehicle or may be a plurality of vehicles of the same vehicle model. It will be described with reference to FIG. 5 assuming that each of the first to fifth vehicle models is a single vehicle and the cumulative energy efficiency graph is generated based on data of single vehicles.

The battery diagnosis apparatus 100 may diagnose whether the battery pack 101 has been replaced, based on a result of comparing the cumulative energy efficiency shown in FIG. 5 with the threshold values included in the analysis table 42 shown in FIG. 4B.

Referring to the analysis table 42 of FIG. 4B and the cumulative energy efficiency graph of FIG. 5, when the diagnosis target vehicle 10 corresponds to the first vehicle model, a threshold value for the first vehicle model is 6.2 km/kWh and the cumulative energy efficiency of the diagnosis target vehicle 10 does not exceed the threshold value of 6.2 km/kWh, such that the battery diagnosis apparatus 100 may diagnose the battery pack 101 as a non-replaced battery pack. On the other hand, when the diagnosis target vehicle 10 corresponds to the fourth vehicle model, a threshold value for the fourth vehicle model is 6.8 km/kWh and the cumulative energy efficiency of the diagnosis target vehicle 10 exceeds the threshold value of 6.8 km/kWh, such that the battery diagnosis apparatus 101 may diagnose the battery pack 101 as a replaced battery pack.

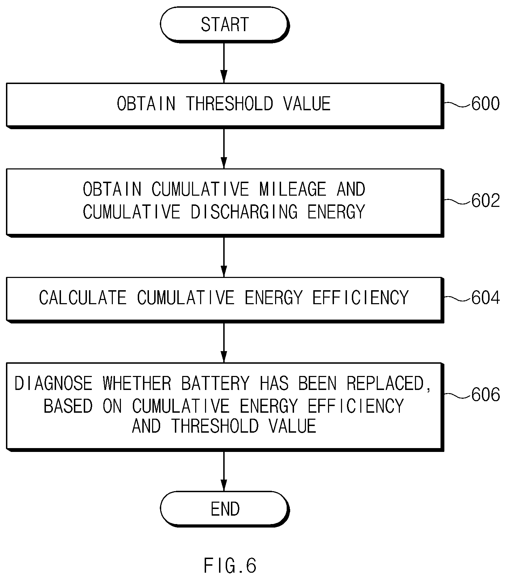

To sum up, for the vehicle models with non-replaced batteries, a deviation between the cumulative energy efficiency shown in FIG. 5 and the threshold value included in the analysis table 42 shown in FIG. 4B is not large, but for the vehicle models with replaced batteries, the deviation between the cumulative energy efficiency shown in FIG. 5 and the threshold value included in the analysis table 42 shown in FIG. 4B is greater than that of other vehicle models. That is, when the battery is not replaced, the reference energy efficiency and the cumulative energy efficiency may be calculated as similar values. FIG. 6 is a flowchart showing an operating method of a battery diagnosis apparatus according to an embodiment disclosed herein.

Referring to FIG. 6, in operation 600, the battery diagnosis apparatus 100 may obtain a threshold value based on reference energy efficiencies of the plurality of vehicles 11, 12, and 13.

In an embodiment, operations of the battery diagnosis apparatus 100

In operation 602, the battery diagnosis apparatus 100 may obtain a cumulative mileage of the diagnosis target vehicle 10 and a cumulative discharging energy of the battery pack 101.

In operation 604, the battery diagnosis apparatus 100 may calculate the cumulative energy efficiency of the diagnosis target vehicle 10 based on the cumulative mileage and the cumulative discharging energy.

In operation 604, the battery diagnosis apparatus 100 may diagnose whether the battery pack 101 has been replaced, based on the cumulative energy efficiency and the threshold value.

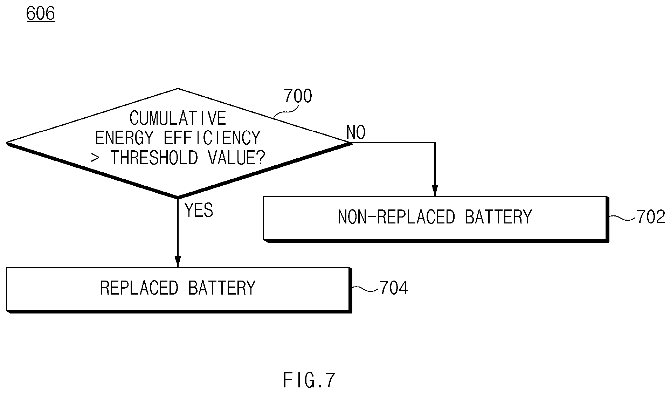

FIG. 7 is a flowchart showing a detailed operating method of operation 606 of a battery diagnosis apparatus according to an embodiment disclosed herein.

Referring to FIG. 7, operation 606 shown in FIG. 6 may include operations 700 to 704 shown in FIG. 7.

In operation 700, the battery diagnosis apparatus 100 may compare the cumulative energy efficiency with the threshold value. The battery diagnosis apparatus 100 may determine whether the cumulative energy efficiency exceeds the threshold value.

In operation 702, the battery diagnosis apparatus 100 may diagnose the battery pack 101 as a replaced battery pack when the cumulative energy efficiency exceeds the threshold value, based on a result of comparing the cumulative energy efficiency with the threshold value.

In operation 704, the battery diagnosis apparatus 100 may diagnose the battery pack 101 as a non-replaced battery pack when the cumulative energy efficiency is less than or equal to the threshold value, based on the result of comparing the cumulative energy efficiency with the threshold value.

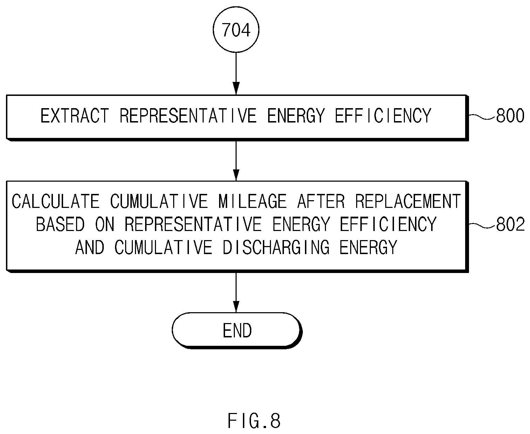

FIG. 8 is a flowchart showing a method, performed by a battery diagnosis apparatus, of calculating a cumulative mileage after replacement, according to an embodiment disclosed herein.

Referring to FIG. 8, operation 800 may be performed after operation 704 of FIG. 7. In operation 800, when the battery pack 101 is a replaced battery pack, the battery diagnosis apparatus 100 may extract a representative energy efficiency based on reference energy efficiencies. Herein, the representative energy efficiency may be an average or a median of the reference energy efficiencies.

In operation 802, the battery diagnosis apparatus 100 may calculate a cumulative mileage after replacement based on the representative energy efficiency and the cumulative discharging energy. The battery diagnosis apparatus 100 may calculate the cumulative mileage based on a product of the representative energy efficiency and the cumulative discharging energy.

Terms such as "include", "constitute" or "have" described above may mean that the corresponding component may be inherent unless otherwise stated, and thus should be construed as further including other components rather than excluding other components. All terms including technical or scientific terms have the same meanings as those generally understood by those of ordinary skill in the art to which the embodiments disclosed herein pertain, unless defined otherwise. The terms used generally like terms defined in dictionaries should be interpreted as having meanings that are the same as the contextual meanings of the relevant technology and should not be interpreted as having ideal or excessively formal meanings unless they are clearly defined in this document.

**EP 4 759 625 A1**

The above description is merely illustrative of the technical idea disclosed herein, and various modifications and variations will be possible without departing from the essential characteristics of the embodiments disclosed herein by those of ordinary skill in the art to which the embodiments disclosed herein pertains. Therefore, the embodiments disclosed herein are intended for description rather than limitation of the technical spirit of the embodiments disclosed herein and the scope of the technical spirit of the present disclosure is not limited by these embodiments disclosed herein. The protection scope of the technical spirit disclosed herein should be interpreted by the following claims, and all technical spirits within the same range should be understood to be included in the range of this document.

**Claims**

1.  A battery diagnosis apparatus comprising: a communication circuit configured to:

    obtain a cumulative mileage of a diagnosis target vehicle and a cumulative discharging energy of a battery mounted on the diagnosis target vehicle; and
    obtain reference energy efficiencies of a plurality of vehicles of a same model as the diagnosis target vehicle;
    a first processor configured to calculate a threshold value, which is a criterion for replacement of a battery, based on the reference energy efficiencies; and
    a second processor configured to:

        calculate a cumulative energy efficiency based on the cumulative mileage and the cumulative discharging energy; and
        diagnose whether the battery has been replaced, based on the cumulative energy efficiency and the threshold value.

2.  The battery diagnosis apparatus of claim 1, wherein each of the reference energy efficiencies is calculated each time when each of the plurality of vehicles starts traveling and ends the traveling for a designated time.

3.  The battery diagnosis apparatus of claim 1, wherein the first processor is further configured to calculate the threshold value by using an inter quartile range (IQR) for the reference energy efficiencies.

4.  The battery diagnosis apparatus of claim 1, wherein the second processor is further configured to diagnose whether the battery has been replaced, based on a result of comparing the cumulative energy efficiency with the threshold value.

5.  The battery diagnosis apparatus of claim 4, wherein the second processor is further configured to diagnose the battery as a replaced battery when the cumulative energy efficiency exceeds the threshold value.

6.  The battery diagnosis apparatus of claim 5, wherein the first processor is further configured to extract a representative energy efficiency representing an energy efficiency of the diagnosis target vehicle based on an average and a standard deviation of the reference energy efficiencies, and
    the second processor is further configured to calculate a cumulative mileage after replacement from a point in time when the battery is mounted on the diagnosis target vehicle, based on the representative energy efficiency and the cumulative discharging energy of the battery.

7.  The battery diagnosis apparatus of claim 1, wherein the communication circuit is further configured to transmit diagnosis information comprising whether the battery has been replaced to a user terminal.

8.  An operating method of a battery diagnosis apparatus, the operating method comprising:

    obtaining a cumulative mileage of a diagnosis target vehicle and a cumulative discharging energy of a battery mounted on the diagnosis target vehicle;
    obtaining reference energy efficiencies of a plurality of vehicles of a same model as the diagnosis target vehicle;
    calculating a threshold value, which is a criterion for replacement of a battery, based on the reference energy efficiencies;
    calculating a cumulative energy efficiency based on the cumulative mileage and the cumulative discharging energy; and
    diagnosing whether the battery has been replaced, based on the cumulative energy efficiency and the threshold value.

9. The operating method of claim 8, wherein each of the reference energy efficiencies is calculated each time when each of the plurality of vehicles starts traveling and ends the traveling for a designated time.

10. The operating method of claim 8, wherein the calculating of the threshold value comprises calculating the threshold value by using an inter quartile range (IQR) for the reference energy efficiencies.

11. The operating method of claim 8, wherein the diagnosing comprises diagnosing whether the battery has been replaced, based on a result of comparing the cumulative energy efficiency with the threshold value.

12. The operating method of claim 11, wherein the diagnosing comprises diagnosing the battery as a replaced battery when the cumulative energy efficiency exceeds the threshold value.

13. The operating method of claim 12, further comprising:

extracting a representative energy efficiency representing an energy efficiency of the diagnosis target vehicle based on an average and a standard deviation of the reference energy efficiencies, and
calculating a cumulative mileage after replacement from a point in time when the battery is mounted on the diagnosis target vehicle, based on the representative energy efficiency and the cumulative discharging energy.

14. The operating method of claim 8, further comprising transmitting diagnosis information comprising whether the battery has been replaced to a user terminal.

FIRST
VEHICLE
11

BATTERY PACK
111

DIAGNOSIS TARGET VEHICLE
10

BATTERY PACK
101

BATTERY DIAGNOSIS
APPARATUS
100

USER TERMINAL
150

SECOND
VEHICLE
12

BATTERY PACK
121

THIRD
VEHICLE
13

BATTERY PACK
131

FIG.1

100

```
┌─────────────────┐          ┌─────────────────┐
│     MEMORY      │~102      │  COMMUNICATION  │~104
│                 │          │     CIRCUIT     │
└────────┬────────┘          └────────┬────────┘
         │                            │
─────────┴────────────────────────────┴──────────────────
                    │                            │
         ┌──────────┴──────┐          ┌──────────┴──────┐
         │     FIRST       │~106      │     SECOND      │~108
         │   PROCESSOR     │          │   PROCESSOR     │
         └─────────────────┘          └─────────────────┘
```

FIG.2

FIG.3

40

FIG.4A

42

| | AVERAGE | STANDARD DEVIATION | MINIMUM VALUE | MAXIMUM VALUE | THRESHOLD VALUE |
|---|---|---|---|---|---|
| FIRST VEHICLE | 4.33 | 0.61 | 2.09 | 10.43 | 6.2 |
| SECOND VEHICLE | 5.49 | 0.91 | 1.11 | 11.40 | 7.8 |
| THIRD VEHICLE | 4.20 | 0.58 | 1.71 | 7.38 | 6.0 |
| FOURTH VEHICLE | 5.10 | 0.59 | 1.81 | 7.56 | 6.8 |
| FIFTH VEHICLE | 4.39 | 0.58 | 1.48 | 7.01 | 6.5 |

FIG.4B

FIG.5

START

OBTAIN THRESHOLD VALUE ～600

OBTAIN CUMULATIVE MILEAGE AND
CUMULATIVE DISCHARGING ENERGY ～602

CALCULATE CUMULATIVE ENERGY EFFICIENCY ～604

DIAGNOSE WHETHER BATTERY HAS BEEN REPLACED,
BASED ON CUMULATIVE ENERGY EFFICIENCY
AND THRESHOLD VALUE ～606

END

FIG.6

<u>606</u>

700

CUMULATIVE
ENERGY EFFICIENCY
> THRESHOLD VALUE?

NO

YES

NON-REPLACED BATTERY    ~702

REPLACED BATTERY    ~704

FIG.7

( 704 )

EXTRACT REPRESENTATIVE ENERGY EFFICIENCY ⌇800

CALCULATE CUMULATIVE MILEAGE AFTER REPLACEMENT BASED ON REPRESENTATIVE ENERGY EFFICIENCY AND CUMULATIVE DISCHARGING ENERGY ⌇802

END

FIG.8

## INTERNATIONAL SEARCH REPORT

| International application No. |
|---|
| **PCT/KR2024/014112** |

**A.    CLASSIFICATION OF SUBJECT MATTER**

**B60L 58/16**(2019.01)i; **G01R 31/367**(2019.01)i; **B60L 3/12**(2006.01)i

According to International Patent Classification (IPC) or to both national classification and IPC

**B.    FIELDS SEARCHED**

Minimum documentation searched (classification system followed by classification symbols)

B60L 58/16(2019.01); B60L 3/00(2006.01); B60L 50/50(2019.01); B60L 58/12(2019.01); G01C 21/34(2006.01); G01R 31/36(2006.01); G06Q 50/30(2012.01); G08G 1/13(2006.01); H01M 10/42(2006.01); H01M 10/48(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 거리(distance), 배터리(battery), 방전(discharge), 교체(replacement), 전비(power consumption)

**C.    DOCUMENTS CONSIDERED TO BE RELEVANT**

| Category* | Citation of document, with indication, where appropriate, of the relevant passages | Relevant to claim No. |
|---|---|---|
| Y | JP 2021-077448 A (HONDA MOTOR CO., LTD.) 20 May 2021 (2021-05-20)<br>See paragraphs [0064]-[0095]; and figure 4. | 1-14 |
| Y | KR 10-2013-0129738 A (HYUNDAI MOTOR COMPANY) 29 November 2013 (2013-11-29)<br>See paragraphs [0077]-[0078]. | 1-14 |
| A | KR 10-2022-0098981 A (HYUNDAI KEFICO CORPORATION) 12 July 2022 (2022-07-12)<br>See paragraphs [0031]-[0070]; and figure 1. | 1-14 |
| A | KR 10-2017-0013019 A (KT CORPORATION) 06 February 2017 (2017-02-06)<br>See paragraphs [0024]-[0071]; and figure 4. | 1-14 |
| A | JP 2022-140890 A (HONDA MOTOR CO., LTD.) 29 September 2022 (2022-09-29)<br>See paragraphs [0016]-[0087]; and figure 5. | 1-14 |

☐ Further documents are listed in the continuation of Box C.    ☑ See patent family annex.

| | |
|---|---|
| *    Special categories of cited documents: | "T"  later document published after the international filing date or priority date and not in conflict with the application but cited to understand the principle or theory underlying the invention |
| "A"  document defining the general state of the art which is not considered to be of particular relevance | |
| "D"  document cited by the applicant in the international application | "X"  document of particular relevance; the claimed invention cannot be considered novel or cannot be considered to involve an inventive step when the document is taken alone |
| "E"  earlier application or patent but published on or after the international filing date | |
| "L"  document which may throw doubts on priority claim(s) or which is cited to establish the publication date of another citation or other special reason (as specified) | "Y"  document of particular relevance; the claimed invention cannot be considered to involve an inventive step when the document is combined with one or more other such documents, such combination being obvious to a person skilled in the art |
| "O"  document referring to an oral disclosure, use, exhibition or other means | |
| "P"  document published prior to the international filing date but later than the priority date claimed | "&"  document member of the same patent family |

| Date of the actual completion of the international search | Date of mailing of the international search report |
|---|---|
| **27 December 2024** | **27 December 2024** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

## INTERNATIONAL SEARCH REPORT
### Information on patent family members

International application No.

**PCT/KR2024/014112**

| Patent document cited in search report | | | Publication date (day/month/year) | Patent family member(s) | | | Publication date (day/month/year) |
|---|---|---|---|---|---|---|---|
| JP | 2021-077448 | A | 20 May 2021 | CN | 112776655 | A | 11 May 2021 |
| | | | | JP | 7030091 | B2 | 04 March 2022 |
| KR | 10-2013-0129738 | A | 29 November 2013 | CN | 103419787 | A | 04 December 2013 |
| | | | | CN | 103419787 | B | 02 October 2018 |
| | | | | DE | 102012214962 | A1 | 21 November 2013 |
| | | | | DE | 102012214962 | B4 | 17 March 2022 |
| | | | | JP | 2013-243899 | A | 05 December 2013 |
| | | | | JP | 6009271 | B2 | 19 October 2016 |
| | | | | US | 2013-0311016 | A1 | 21 November 2013 |
| | | | | US | 9037327 | B2 | 19 May 2015 |
| KR | 10-2022-0098981 | A | 12 July 2022 | KR | 10-2505810 | B1 | 06 March 2023 |
| KR | 10-2017-0013019 | A | 06 February 2017 | KR | 10-1807210 | B1 | 08 December 2017 |
| JP | 2022-140890 | A | 29 September 2022 | CN | 115081669 | A | 20 September 2022 |
| | | | | JP | 7186254 | B2 | 08 December 2022 |
| | | | | US | 11656086 | B2 | 23 May 2023 |
| | | | | US | 2022-0291004 | A1 | 15 September 2022 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020230127482